# EUROPEAN PATENT APPLICATION

(11) **EP 2 227 077 A2**
(43) Date of publication of application: **08.09.2010**
(21) Application number: 10155507.6
(22) Date of filing: 04.03.2010
(51) Int. Cl.: H05K 7/14

(54) **Electronic apparatus**

(30) Priority: 05.03.2009 JP 2009052232
(71) Applicant: Fujitsu Limited, Kawasaki-shi, Kanagawa 211-8588 (JP)
(72) Inventor: Kondou, Takahiro, Kawasaki-shi, Kanagawa 211-8588 (JP); Ishikawa, Koji, Kawasaki-shi, Kanagawa 211-8588 (JP); Tamura, Akira, Kawasaki-shi, Kanagawa 211-8588 (JP)
(74) Representative: Stebbing, Timothy Charles

(57) **Abstract**

An electronic apparatus (1) includes a cabinet (2) which includes a first face (2c) capable of being opened, a second face (2b)perpendicular to the first face, and a third face (2a) facing the second face (2a), a first connector (3) which is disposed over the second face (2b) inside the cabinet (2) and a fitting face of which faces the third face (2a), and a substrate unit (4) which includes a second connector (5) attached to the first connector (3), a first edge included in the second connector, a second edge on an opposite side of the first edge, and an engaging part disposed on the second edge.

## Description

This application is based upon and claims the benefit of priority of the prior Japanese Patent Application No.2009- 52232, filed on March 5, 2009.

The present invention relates to an electronic apparatus.

In recent years, there has been an increasing demand that a space between adjacent large-scale electronic apparatuses, such as large-scale servers and large-scale computers be reduced as much as possible in relation to installation of the large-scale electronic apparatuses. This is because it is preferred for a large number of large-scale electronic apparatuses to be installed within a limited floor space. On the other hand, however, there may be cases where the reduction in space between adjacent electronic apparatuses (especially, the space between adjacent installed electronic apparatuses in a front-rear direction) is difficult to achieve when considering a removal operation of substrates (boards) attached inside a cabinet. The large-scale electronic apparatus includes a cabinet. On the side of a rear-face plate inside the cabinet, there are disposed one or more connectors. A mounting edge (fitting face) of each of the one or more connectors faces on the side of a front face of the cabinet. For example, a main substrate is attached inside the cabinet. This main substrate includes connectors whose mounting edges face the front of the cabinet. Other substrates are electrically connected to the main substrate through the other connectors. In other words, the other substrates are electrically connected in a vertical (perpendicular) manner relative to the main substrate installed along the rear-face plate of the cabinet. In the above case, the mounting direction of the connector is at right angles to the main substrate. Due to this, the other substrate is preferably extracted perpendicular to the main substrate when removing the other substrate from the main substrate. When the other substrate is extracted in this way and removed from the side of the front face of the cabinet, it is desirable that a space between one electronic apparatus and another electronic apparatus is at least substantially equal to or greater than the dimension of depth of the other substrate.

Due to the circumstance discussed above, it has been conventionally very difficult to reduce the space between the installed electronic apparatuses in the front-rear direction. That is to say, a reduction in the space between the installed cabinets in the front-rear direction without considering its results have been very difficult to achieve over the years.

To address the circumstance discussed above, removal of the substrate from the side face of the cabinet allows the installation of the electronic apparatuses with a reduced space in a front-rear direction. One or more aisles for an administrator performing maintenance are provided in installing a large number of electronic apparatuses in an arranged manner. Since such an aisle typically has a certain degree of width, operations of removing the substrate from the side face of the cabinet may be facilitated by taking advantage of the one or more aisles provided beside the side faces of the electronic apparatuses.

Japanese Laid down-open Patent Publication No. 10-178289 discusses a board that is removable from a side face of a cabinet. For example, it is discussed a frame, which is formed in combination with an actuator bar having a substantially U-shaped channel, serves as a support of a circuit board. A side face part of the frame is equipped with slots that slidably receive pins extending across the channel of the actuator bar. This slot is inclined, and when the actuator bar is pushed forward, the direction of motion of the frame is converted in line therewith. That is to say, the frame is capable of being moved perpendicular to a main board disposed along a rear-face plate inside a cabinet. As a result thereof, connectors disposed at an edge of the circuit board held by the frame may be fitted, in a perpendicular (vertical) manner, with mating connectors on a main board.

According to an embodiment of the invention, an electronic apparatus includes a cabinet which includes a first face capable of being opened, a second face perpendicular to the first face, and a third face facing the second face. The electronic apparatus further includes a first connector which is disposed over the second face inside the cabinet and a fitting face (mounting edge) of which faces the third face, and a substrate unit which includes a second connector fitted with (attached to) the first connector, a first edge included in the second connector, a second edge on an opposite side of the first edge, and an engaging part disposed on the second edge. A movable part is provided, which is capable of engaging with the engaging part, and the substrate unit engaged with the movable part by a jig including a handle part capable of causing the movable part to move are caused to move back and forth in a fitting (attaching) direction of the first connector and the second connector.

The advantages of the invention will be realized and attained by means of the elements and combinations particularly pointed out in the claims.

It is to be understood that both the foregoing general description and the following detailed description are exemplary and explanatory and are not restrictive of the invention, as claimed.

Reference is made, by way of example only, to the accompanying drawings in which:
Fig. 1 illustrates a schematic view of an electronic apparatus system according to an embodiment that is viewed from above.

Fig. 2A illustrates a perspective view of a detachable-attachable substrate included in the electronic apparatus system according to the embodiment and Fig. 2B illustrates an enlarged view of a circled portion A in Fig. 2A.

Fig. 3 illustrates a perspective view of a part of a cabinet according to an embodiment.

Fig. 4A illustrates a perspective view of an insertion-extraction jig according to an embodiment and indicates a state where an operation part is caused to move back toward a main body part, and Fig. 4B illustrates a perspective view of the insertion-extraction jig according to the embodiment and indicates a state where the operation part is caused to move forward from the main body part.

Fig. 5 illustrates an enlarged exploded view of the insertion-extraction jig according to an embodiment.

Fig. 6A and Fig. 6B illustrate an explanatory view indicating operation of the insertion-extraction jig according to an embodiment.

Fig. 7A illustrates a perspective view indicating a procedure for attaching the insertion-extraction jig to the detachable-attachable substrate according to an embodiment, Fig. 7B illustrates an enlarged view of a dotted circle portion B of Fig. 7A, and Fig. 7C illustrates an enlarged view of a dotted circle portion C of Fig. 7A.

Fig. 8 illustrates a perspective view of a guide member disposed inside the cabinet according to an embodiment.

Fig. 9 illustrates a perspective view indicating a procedure for installing the detachable-attachable substrate with the insertion-extraction jig attached thereto into the cabinet according to an embodiment.

Fig. 10 illustrates an explanatory view for comparing a state in which a second connector is fitted with a first connector and a state in which the second connector is extracted from the first connector according to an embodiment.

Fig. 11 illustrates a perspective view indicating a procedure for extracting the insertion-extraction jig from the detachable-attachable substrate according to an embodiment.

Since the actuator bar, described above, integrally in combination with the frame is housed within the cabinet, the actuator bar is not capable of being removed. For this reason, it is desired that an actuator bar be provided (prepared with respect to) each of the frames. Furthermore, the motion of the frame moving toward the main board is achieved by converting the motion of the actuator bar pushed forward in a horizontal direction. However, there may be a possibility that pressing force for achieving enough fitting force between the connectors is not obtained.

Hereinafter, an embodiment of the present invention will be described with reference to drawings. Note, however, that dimensions, proportions, and so on of respective parts may not be illustrated so that the dimensions, the proportions, and so on thereof correctly reflect an actual electronic apparatus system, in the drawings. Moreover, there may be cases where details of the respective parts are omitted in the drawings.

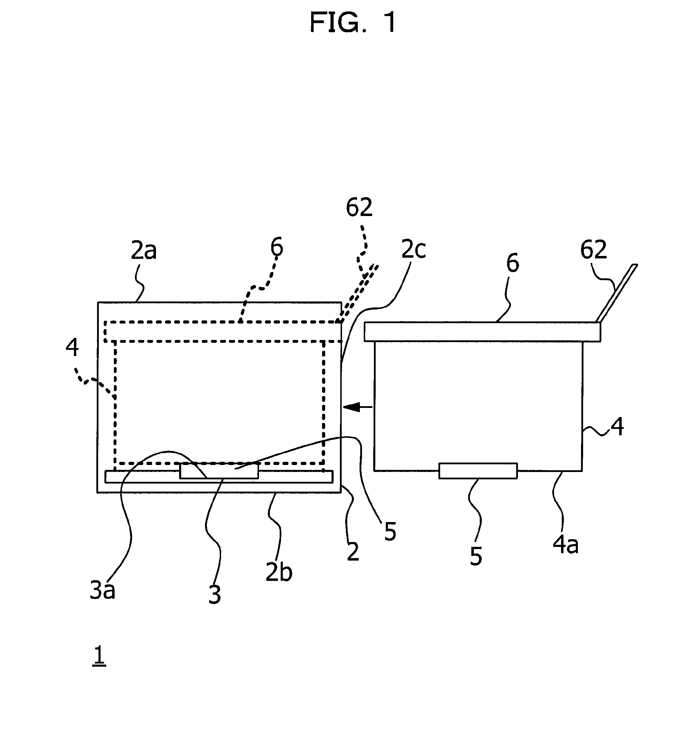

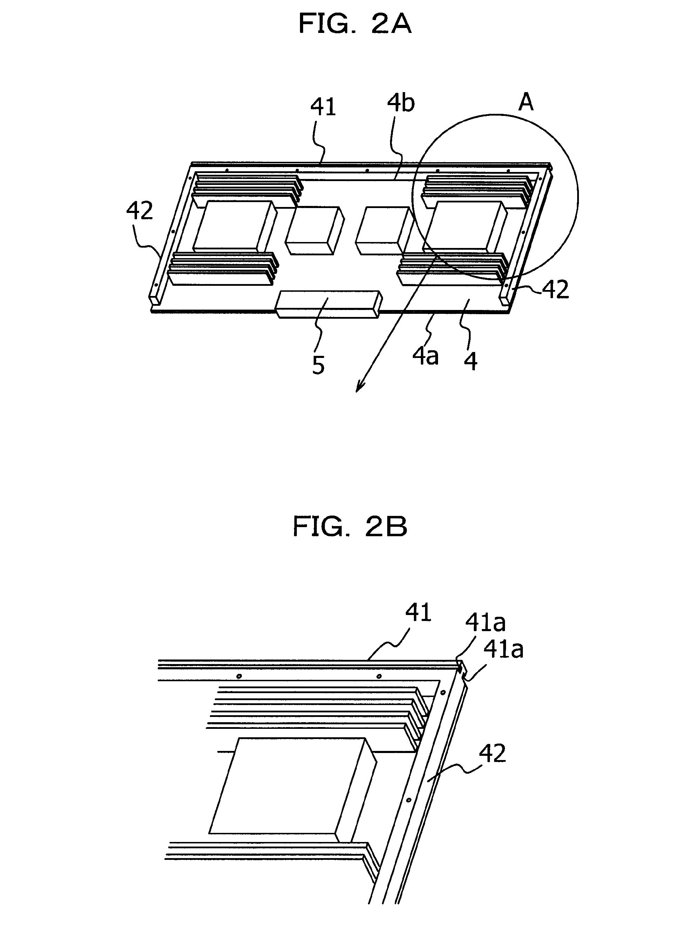

Fig. 1 illustrates a schematic view of an electronic apparatus system 1 according to an embodiment. Note that Fig. 1 is viewed from above. According to the embodiment, the electronic apparatus system 1 includes a cabinet 2 and first connector 3 (or in an alternative embodiment, first connectors 3). A side face 2c of the cabinet 2 is capable of being opened. The first connector 3, with its fitting face 3a facing toward a front face 2a of the cabinet 2, is disposed on the side of a rear face plate 2b inside the cabinet 2. Furthermore, there is a detachable-attachable substrate 4 including a first edge 4a having a second connector 5, fitted with the first connector 3, thereon. This detachable-attachable substrate 4 corresponds to a substrate in an embodiment of the present invention, and is typically called a "daughter board." The detachable-attachable substrate 4 is installed into, or removed from (or both), the cabinet 2 from the side of the side face 2c of the cabinet 2. The detachable-attachable substrate 4 includes a reinforcement member 42 (illustrated in Fig. 2A) extending toward the first edge 4a from the side of a second edge 4b in Fig. 2A.

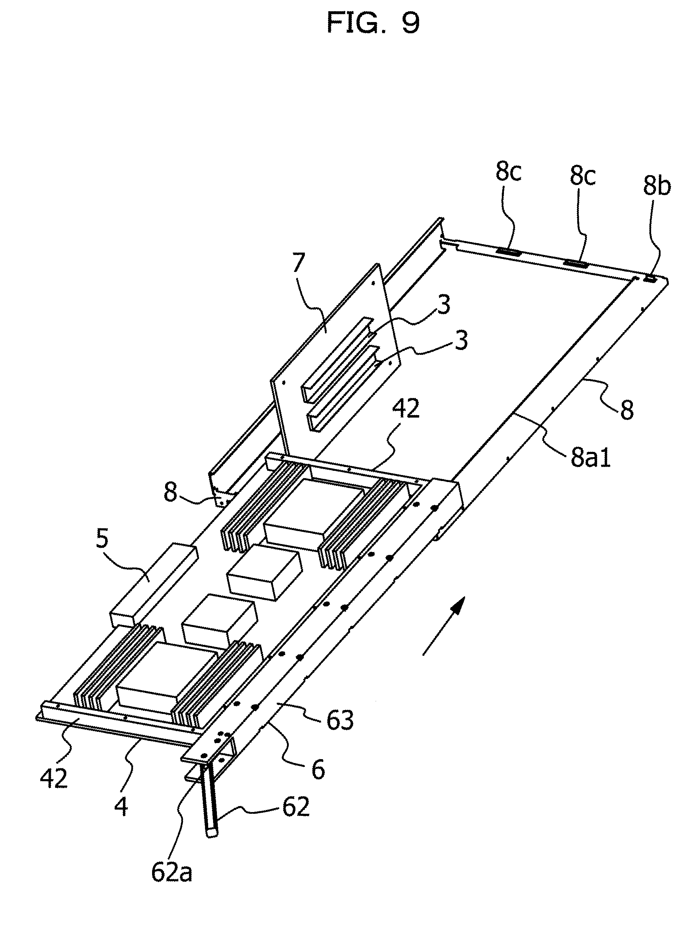

The electronic apparatus system 1 includes an insertion-extraction jig 6 which is attached to the detachable-attachable substrate 4 and by which the second connector 5 is inserted into, and extracted from, the first connector 3. As described above, by virtue of the reinforcement member 42 (illustrated in Fig. 2a) disposed on the detachable-attachable substrate 4, force pressing the detachable-attachable substrate 4 toward a fixed substrate 7 (illustrated in Fig. 9) by the insertion-extraction jig 6 may be effectively transmitted to the second connector 5. Strong fitting between the first connector 3 and the second connector 5 may be achieved by the above mechanism. In addition, the reinforcement member 42 is capable of achieving advantageous effects of reducing a warp and a bend, and of suppressing damage of the detachable-attachable substrate 4.

Fig. 2A illustrates a perspective view of the detachable-attachable substrate 4 included in the electronic apparatus system 1 according to the embodiment, and Fig. 2B illustrates an enlarged view of a circled portion A in Fig. 2A. Hereinafter described with reference to Figs 2A and 2B, the detachable-attachable substrate 4 includes a substrate-side engaging part by which the insertion-extraction jig 6 is engaged with the second edge 4b on the opposite side of the first edge 4a. The substrate-side engaging part 41 is disposed, along the second edge 4b, as engaging grooves 41a formed on a front face and a back face of the detachable-attachable substrate 4.

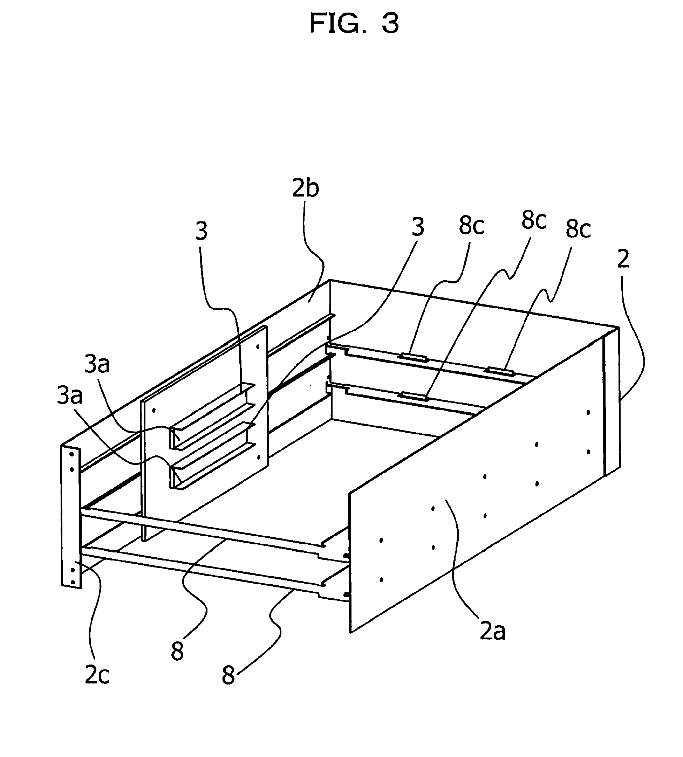

Fig. 3 illustrates a partial perspective view of the cabinet 2 according to an embodiment, and the detachable-attachable substrate 4 is installed into or removed (or both) from the side of the side face 2c of the cabinet 2, as described above. The detachable-attachable substrate 4 installed into the cabinet 2 is housed inside the cabinet 2 along a guide member 8.

The fixed substrate 7 typically called a "back plane board" is perpendicularly disposed on the side of the rear face plate 2b inside the cabinet 2. The first connector3 is (or in an alternative embodiment the first connectors 3 are) disposed on the fixed substrate 7.

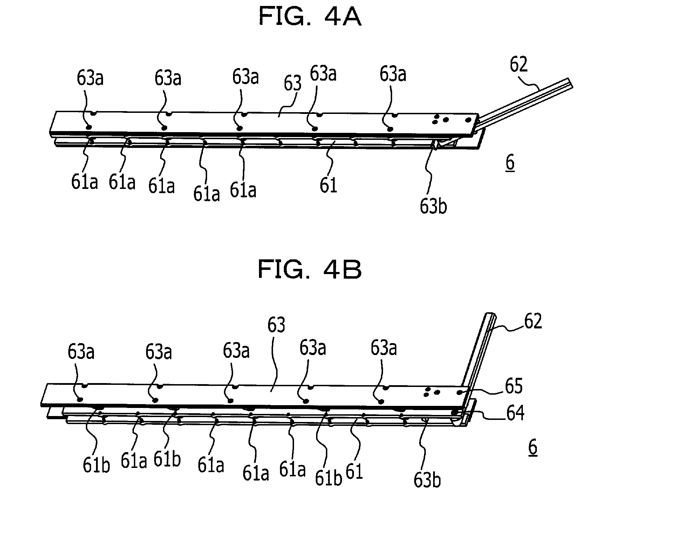

Both of Figs. 4A and 4B illustrate perspective views of the insertion-extraction jig 6 according to an embodiment. The insertion-extraction jig 6 is a member by which the second connector 5 disposed on the detachable-attachable substrate 4 in Fig. 2A is inserted into or extracted from the first connector 3 in Fig. 3. As illustrated in Figs. 4A and 4B, the insertion-extraction jig 6 includes an operation part 61. On the operation part 61, there are disposed jig-side engaging parts 61a. The jig-side engaging parts 61a are not only caused to move back and forth in a fitting direction of the first connector 3 and the second connector 5 but also are engaged with the substrate-side engaging part 41. The jig-side engaging parts 61a are not only slidable relative to the engaging grooves 41a forming the substrate-side engaging part 41 but also are formed as pin members engaged with the engaging grooves 41a.

The jig-side engaging parts 61a may have shapes capable of being engaged with the engaging grooves 41a. In consequence, friction produced during sliding can be reduced by forming their shapes as the pin-shape members, although it is also possible to form their shapes like rails.

The insertion-extraction jig 6 further includes a handle part 62 by which the operation part 61 is caused to move back and forth.

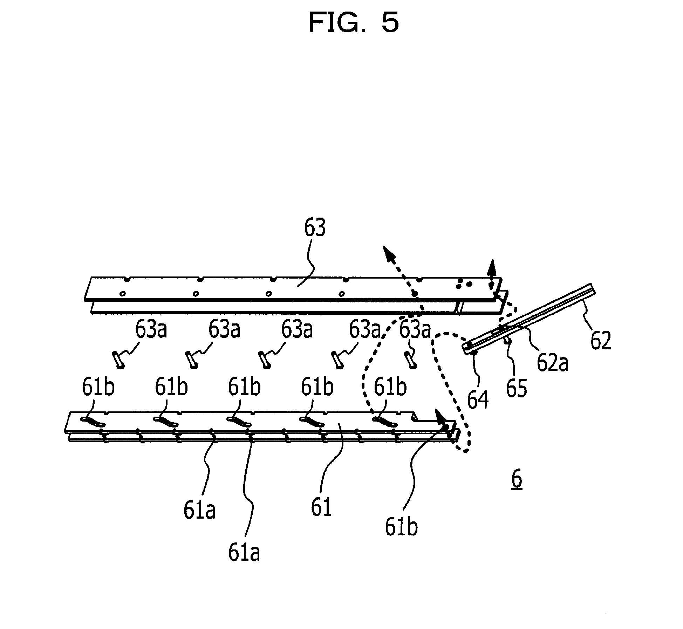

Fig. 5 illustrates an enlarged exploded view of the insertion-extraction jig 6 according to an embodiment. With reference to Fig. 5, detailed description of the insertion-extraction jig 6 will be described.

The insertion-extraction jig 6 includes a main body part 63 having pin members 63a thereon. The pin members 63a are detachably attached to the main body part 63 and are inserted through crank grooves 61b of the operation part 61, as will be described below. The handle member 62 is formed in a lever-like shape having a slide groove 62a. The handle member 62 is held via a point-of-effort shaft 64 by a shaft hole 61b formed at an end of the operation part 61 and is connected via a fulcrum shaft 65, inserted through the slide groove 62a, with the main body part 63. With the above mechanism, the operation part 61 movable relative to the main body part 63 may be achieved by applying rotational motion in which the fulcrum shaft 65 serves as a fulcrum, to the handle member 62.

The operation part 61 includes the crank grooves 61b with which the pin members 63a are engaged. In addition, the operation part 61 is caused to move back and forth in the fitting direction of the first connector 3 and the second connector 5 by the pin members 63a relatively moving along the crank grooves 61b by the handle member 62 being operated. That is to say, the operation part 61 is retractably attached to the main body part 63.

The insertion-extraction jig 6 with the structure described above is not only capable of moving the operation part 61 back toward the main body part 63 as illustrated in Fig. 4A but also capable of moving the operation part 61 forward from the main body part 63 as illustrated in Fig. 4B.

In addition, the main body part 63 includes a positioning member 63b (in Figs. 4A and 4B) for the detachable-attachable substrate 4. This positioning member 63b is disposed adjacent an end of the handle member 62. When housing the detachable-attachable substrate 4 inside the cabinet 2, the detachable-attachable substrate 4 is capable of being pressed until a certain position by the positioning member 63b being come in contact with an end face of the detachable-attachable substrate 4. Moreover, the detachable-attachable substrate 4 may undergo a force which urges the detachable-attachable substrate 4 to move in an oblique direction when the handle member 62 is handled while maintaining a state where the insertion-extraction jig 6 is attached to the detachable-attachable substrate 4. However, such motion by the detachable-attachable substrate 4 may be restricted because of the positioning member 63b coming in contact therewith.

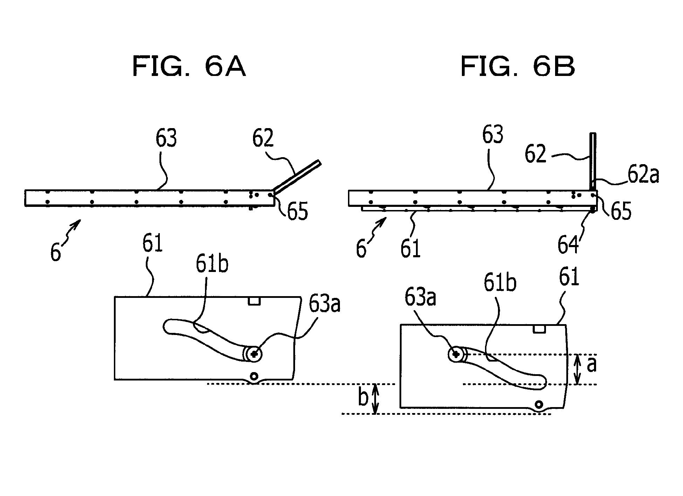

Figs. 6A and 6B illustrate views explaining operation of the insertion-extraction jig 6 according to an embodiment. Fig. 6A illustrates a state where the handle member 62 is operated such that the handle member 62 is inclined to come closer to its horizontal position relative to the main body part 63. In the state described above, the pin member 63a is caused to move to the lower end side of the crank groove 61b as illustrated in Fig. 6A. With this motion, the operation part 61 is caused to move back toward the main body part 63. On the other hand, Fig. 6B illustrates a state where the handle member 62 is operated such that the handle member 62 is caused to stand closer to its perpendicular (upright) position relative to the main body part 63. In the state described above, the pin member 63a is caused to move to an upper end side of the crank groove 61b as illustrated in Fig. 6B. With this motion, the operation part 61 is caused to move forward from the main body part 63.

In installing or removing the detachable-attachable substrate 4 into or from the cabinet 2, the insertion-extraction jig 6 assumes the state as indicated by Fig. 6A. On the other hand, the insertion-extraction jig 6 assumes the state as indicated by Fig. 6B under the state where the first connector 3 is fitted with the second connector 5.

Altering a width "a" of the crank groove 61b allows an insertion-extraction stroke "b" to be adjusted.

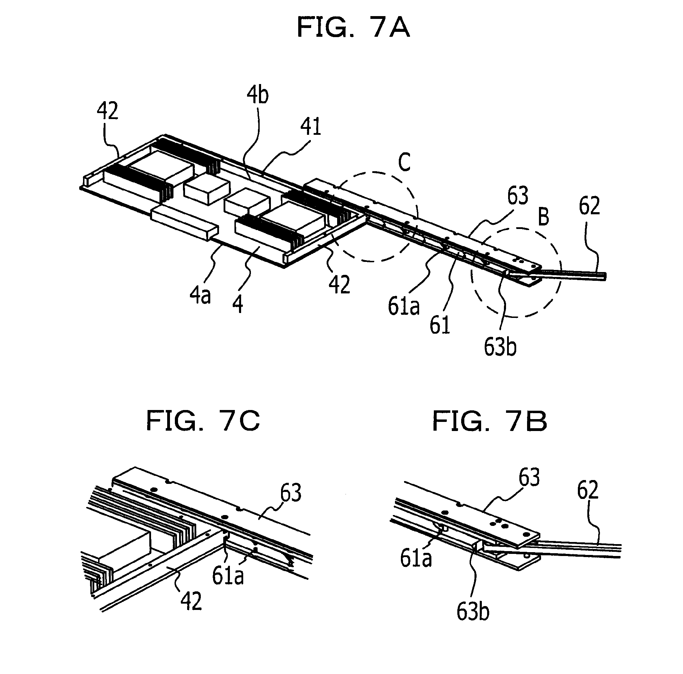

Fig. 7A illustrates a perspective view indicating a procedure for attaching the insertion-extraction jig 6 to the detachable-attachable substrate 4 according to an embodiment. Fig. 7B illustrates an enlarged view of a dotted circle portion B illustrated in Fig. 7A. Fig. 7C illustrates an enlarged view of a dotted circle portion C in Fig. 7C. In attaching the insertion-extraction jig 6 to the detachable-attachable substrate 4, the insertion-extraction jig 6 is kept in the state where the handle member 62 is inclined as illustrated in Fig. 6B. The jig-side engaging part 61a is caused to slide along the engaging grooves 41a to engage the both members with each other, as illustrated in Fig. 7C while maintaining the above state.

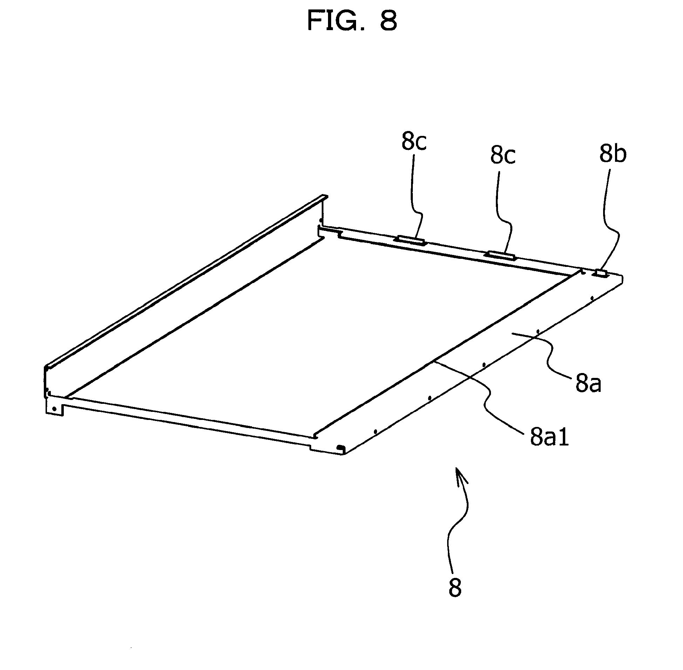

Next, the guide member 8 included in the cabinet 2 will be described with reference to Fig. 8 in accordance with an embodiment of the invention. The guide member 8 is a frame-like member and includes a flat part 8a. A guide piece 8a1 is disposed at an edge part inside the flat part 8a along an installing direction and a removing direction of the detachable-attachable substrate 4. The guide piece 8a1 is formed by folding the edge part inside the flat part 8a upward. When the detachable-attachable substrate 4 is installed into and removed from the cabinet 2, the main body part 63 of the insertion-extraction jig 6 is put onto the flat part 8a. Then, the insertion-extraction jig 6 is caused to slidingly move such that the edge part of the main body part 63 follows the guide piece 8a1.

The position of the guide piece 8a1 is specified such that the second connector 5 does not impede the first connector 3 when the insertion-extraction substrate 4 is installed inside the cabinet 2.

In addition, the guide member 8 includes stoppers 8b and 8c at a far side in the installing direction of the detachable-attachable substrate 4. When the detachable-attachable substrate 4 is installed inside the cabinet 2, the detachable-attachable substrate 4 is pressed thereinto until the detachable-attachable substrate 4 comes in contact with the stoppers 8b and 8c. A plurality stages of such guide members 8 is disposed inside the cabinet 2.

Note that the detachable-attachable substrate 4, which has been installed into the cabinet 2 inside which the first connector 3 and the second connector 5 has been fitted with each other, may be kept in a state where the detachable-attachable substrate 4 is only put onto the guide member 8 or may be fixed to the guide member 8 with screws and so on. With the fixation, influences due to vibration or the like of the detachable-attachable substrate 4 may be alleviated.

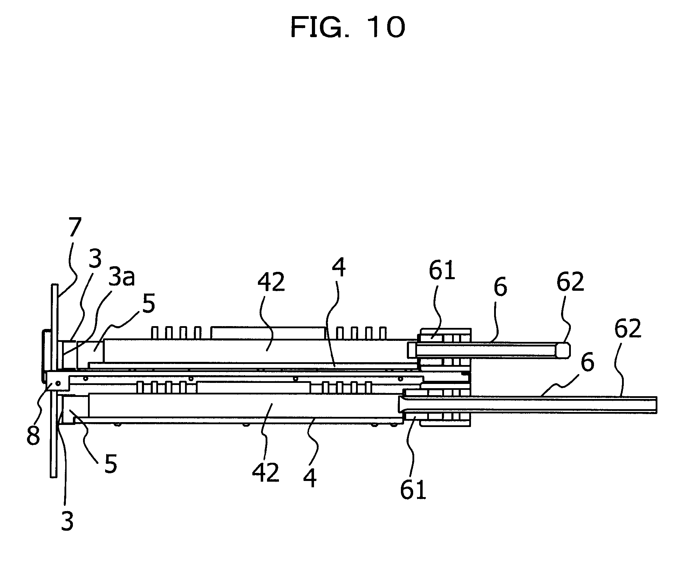

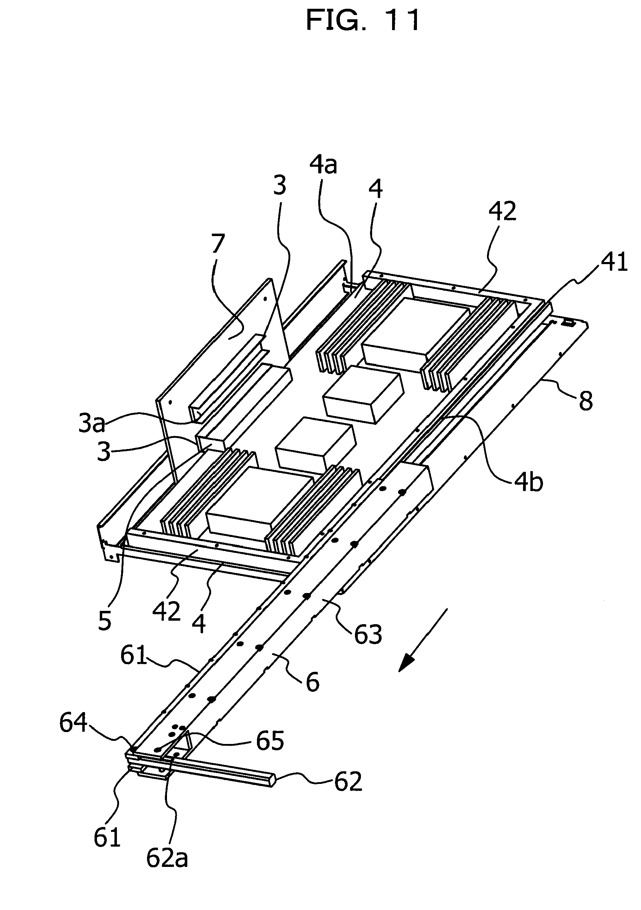

Next, how to use the insertion-extraction jig will be described. Fig. 9 illustrates a perspective view indicating a procedure for installing the detachable-attachable substrate 4 with the insertion-extraction jig 6 attached thereto, inside the cabinet 2 according to an embodiment. Furthermore, Fig. 10 illustrates an explanatory view for comparing the state in which the second connector 5 is fitted with the first connector 5 and the state in which the second connector 5 is extracted from the first connector 3 according to an embodiment. Moreover, Fig. 11 illustrates a perspective view indicating a procedure for extracting the insertion-extraction jig from the detachable-attachable substrate 4 according to an embodiment.

In installing the detachable-attachable substrate 4 inside the cabinet 2, the insertion-extraction jig 6 is attached to the detachable-attachable substrate 4. To attach the insertion-extraction jig 6 to the detachable-attachable substrate 4, first, as described with reference to Fig. 7, the handle member 62 of the insertion-extraction jig 6 is brought into the state where the handle member 62 of the insertion-extraction jig 6 is inclined, the jig-side engaging parts 61a is slid along the engaging grooves 41a, and the insertion-extraction jig 6 is engaged with the detachable-attachable substrate 4. Next, the detachable-attachable substrate 4 is slid on the guide member 8 from the side of the side face 2c of the cabinet 2, so that the detachable-attachable substrate 4 is installed inside the cabinet 2. At this point of time, the main body part 63 of the insertion-extraction jig 6 is adapted to follow the guide piece 8a1 included in the guide member 8 disposed inside the cabinet 2. The detachable-attachable substrate 4 is pressed inside the cabinet 2 until the detachable-attachable substrate 4 comes in contact with the stoppers 8b and 8c. As a result thereof, the state as illustrated in an upper part of Fig. 10 is achieved.

When an end of the detachable-attachable substrate 4 has come in contact with the stoppers 8b and 8c, and the installation of the detachable-attachable substrate 4 into the cabinet 2 is completed, subsequent thereto, operation of fitting the second connector 5 with the first connector 3 is carried out.

To fit the first connector 3 with the second connector 5, as illustrated in Figs. 4A and 4B, the handle member 62 is brought into the state where the handle member 62 is standing. This state allows the operation part 61 coming out of the main body part 63, so that the operation part 61 is caused to move forward in the fitting direction of the first connector 3 and the second connector 5.

The forward motion of the operation part 61 allows the detachable-attachable substrate 4, on which the substrate-side engaging part 41 (engaging grooves 41a) is engaged with the jig-side engaging parts 61a, moving toward the fixed substrate 7. Then, as illustrated in a lower part of Fig. 10, the fitting between the first connector 3 and the second connector 5 is achieved by operating the handle member 62 in a direction such that the handle member 62 is further caused to stand.

After completion of the fitting of the first connector 3 and the second connector 5, as illustrated in Fig. 11, the operation of attaching the detachable-attachable substrate 4 is completed by extracting the insertion-extraction jig 6 while maintaining the state where the handle member 62 is standing. At this point of time, slightly loosening the handle member 62 in a direction where the handle member 62 is inclined as illustrated in Fig. 6A causes the engagement of the jig-side engaging parts 61a and the engaging grooves 41a to be loosened, so that the insertion-extraction jig 6 may be extracted with ease.

The insertion-extraction jig 6 after completion of the fitting operation of one detachable-attachable substrate 4 may be used for the subsequent operation of inserting or extracting the other detachable-attachable substrate 4.

On the other hand, when the detachable-attachable substrate 4, having been installed inside the cabinet 2 inside which the second connector 5 has been fitted with the first connector 5, is removed from the cabinet 2, an operation inverse to the installation operation is performed. That is, first, the handle member 62 is caused to stand, the operation part 61 is inserted from the side of the side face 2c of the cabinet 2 while maintaining the state where the operation part 61 is moved forward, and the jig-side engaging parts 61a are engaged with the substrate-side engaging part 41. In other words, the pin members 63a of the jig-side engaging parts 61a are slid along the engaging grooves 41a until the pin members 63a come in contact with the stopper 8b, so that the jig-side engaging parts 61a is engaged with the substrate-side engaging part 41. With the above operation, the state illustrated in the lower part of Fig. 10 is achieved.

Thereafter, the handle member 62 is operated so that the handle member 62 is inclined as illustrated in the upper part of Fig. 10. This operation causes the operation part 61 to move back toward the main body part 63. Since the operation part 61 and the detachable-attachable substrate 4 are joined together, force in a direction of extracting the second connector 5 from the first connector 3 is exerted on the detachable-attachable substrate 4 along with the backward motion of the operation part 61. Then, the second connector 5 is extracted from the first connector 3, as illustrated in the upper part of Fig. 10.

After the second connector 5 has been extracted from the first connector 3, the detachable-attachable substrate 4 is caused to be slid on the guide member 8 with the insertion-extraction jig 6 to remove the detachable-attachable substrate 4 from the side of the side face 2c of the cabinet 2 while maintaining the state where the handle member 62 is inclined. At this point of time, increasing friction force between the substrate-side engaging part 41 and the jig-side engaging parts 61a while applying force on the side where the handle member 62 is further inclined facilitates the removal of the detachable-attachable substrate 4 and the insertion-extraction jig 6 adapted to be joined together.

As described hereinabove, use of the insertion-extraction jig 6 according to the embodiment not only allows the installation and the removal of the detachable-attachable substrate 4 into and from the side of the side face 2c of the cabinet 2 but also allows the insertion and extraction of the second connector 5 into and from the first connector 3. As a result thereof, when the cabinets 2 are installed, a space between the cabinets 2 spaced apart in the front-rear direction is capable of being reduced.

At this point of time, the insertion-extraction jig 6 is capable of exerting strong fitting force between the connectors and strong extraction force by rotating the handle member 62. Moreover, such force is capable of being made stronger with greater momentum being produced by making the handle member 62 longer.

In addition, since the insertion-extraction jig 6 is capable of being detachably attached to the insertion-extraction substrate 4, preparing only one insertion-extraction jig 6 allows the insertion-extraction operation for the plurality of detachable-attachable substrate 4 to be carried out. That is, preparing the insertion-extraction jig 6 with respect to each of the detachable-attachable substrates 4 is unnecessary, and thus, this is more efficient.

The electronic apparatus system according to the embodiment includes an advantageous effect in which an insertion-extraction jig capable of inserting and extracting a substrate to and from a side face of a cabinet is detachably attached to the substrate, so that strong fitting force between connectors may be achieved.

All examples and conditional language recited herein are intended for pedagogical purposes to aid the reader in understanding the principles of the invention and the concepts contributed by the inventor to furthering the art, and are to be construed as being without limitation to such specifically recited examples and conditions, nor does the organization of such examples in the specification relate to a showing of the superiority and inferiority of the invention. Although the embodiments of the present inventions have been described in detail, it should be understood that the various changes, substitutions, and alterations could be made hereto without departing from the scope of the claims.

## Claims

1. An electronic apparatus comprising:
a cabinet which comprises a first face capable of being opened, a second face perpendicular to the first face, and a third face facing the second face;
a first connector which is disposed over the second face inside the cabinet and a fitting face of which faces the third face; and
a substrate unit which comprises a second connector fitted with the first connector, a first edge included in the second connector, a second edge on an opposite side of the first edge, and an engaging part disposed on the second edge,
wherein a movable part capable of engaging with the engaging part and the substrate unit engaged with the movable part by a jig including a handle part capable of causing the movable part to move is capable of moving back and forth in a fitting direction of the first connector and the second connector.

2. The electronic apparatus according to claim 1, wherein a detachable-attachable substrate comprises a reinforcement member extending from a side of the second edge toward the first edge.

3. The electronic apparatus according to claim 1 or 2, further comprising:
an insertion-extraction jig which comprises a main body part in which a pin member is disposed, the handle part which comprises a slide groove and is formed in a lever-like shape,
wherein the handle part is held via a point-of-effort shaft by an operation part and connected to the main body part via a fulcrum shaft inserted through the slide groove, and
wherein the operation part comprises a crank groove with which the pin member is engaged, the pin member relatively moving along the crank groove by the handle part being operated.

4. The electronic apparatus according to claim 3, wherein the main body part comprises a positioning member for the detachable-attachable substrate.

5. The electronic apparatus according to claim 3, further comprising:
a guide member configured to guide the substrate unit in a direction perpendicular to the first face.

6. A substrate unit comprising:
a substrate which comprises a first edge and a second edge facing the first edge;
a connector which is disposed on the first edge and is fitted with a connector of a cabinet; and
a substrate-side engaging part which is disposed on the second edge and with which an insertion-extraction jig is engaged.

7. The substrate unit according to claim 6, further comprising:
a reinforcement member which extends from a side of the second edge toward the first edge.

8. An insertion-extraction jig comprising:
an operation part comprising a jig-side engaging part which is caused to move back and forth in a fitting direction of a first connector, facing a fitting face on a side of a front face of a cabinet and disposed on a side of a rear face inside the cabinet, and a second connector, disposed on a first edge of a substrate unit, and which is engaged with a substrate-side engaging part disposed on a second edge on an opposite side of the first edge of the substrate unit;
a handle part capable of performing back-and-forth motion of the operation part; and
a main body part on which a pin member is disposed;
wherein the handle part, comprising a slide groove and formed in a lever-like shape, is held via a point-of-effort shaft by the operation part and is connected via a fulcrum shaft, inserted through the slide groove, with the main body part, and the operation part, comprising a crank groove with which the pin member is engaged, is caused to move back and forth in the fitting direction of the first connector and the second connector by the pin member relatively moving along the crank groove by the handle member being operated.

9. The insertion-extraction jig according to claim 8, wherein the main body part comprises a positioning member for the substrate.

10. The substrate unit according to claim 6, wherein the substrate comprises a detachable-attachable substrate.

11. The substrate unit according to claim 10, further comprising engaging grooves formed on a front face and a back face of the detachable-attachable substrate.

12. The insertion-extraction jig according to claim 9, wherein the positioning member is disposed adjacent an end of the handle part.

13. A method for attaching the insertion-extraction jig according to claim 8 to a substrate, the method comprising:
keeping the insertion-extraction jig in a state where the handle part is inclined; and
sliding the jig-side engaging part along engaging grooves to engage the substrate.

14. A method for installing the substrate unit according to claim 6 to a cabinet, the method comprising:
sliding the substrate on a guide member from a side of a side face of the cabinet, wherein the cabinet comprises stoppers at a far side in an installing direction of the substrate;
adapting a main part of an insertion-extraction jig to follow a guide piece included in the guide member disposed inside the cabinet;
pressing the substrate until the substrate comes in contact with the stoppers; and
extracting the insertion-extraction jig.

15. A method for removing the substrate unit according to claim 6 from a cabinet, the method comprising:
causing a handle part to stand;
inserting an operation part from a side of a side face of the cabinet;
operating the handle part so that the handle part is inclined; and
sliding the substrate on a guide member with an insertion-extraction jig to remove the substrate from the side of the side face of the cabinet.
